# EUROPEAN PATENT APPLICATION

(11) **EP 4 361 561 A1**
(43) Date of publication of application: **01.05.2024**
(21) Application number: 22204378.8
(22) Date of filing: 28.10.2022
(51) Int. Cl.: G01C 19/5783, G01C 21/16, G01P 1/02, G01P 15/18, B81B 7/00

(54) **ARRANGEMENT OF CIRCUIT BOARDS FOR AN INERTIAL MEASUREMENT UNIT**

(71) Applicant: Murata Manufacturing Co., Ltd., Nagaokakyo-shi, Kyoto 617-8555 (JP)
(72) Inventor: ENDO, Shigeru, Yokohoma-shi, Kanagawa, 220-0023 (JP)
(74) Representative: Boco IP Oy Ab

(57) **Abstract**

This disclosure describes an arrangement that allows the reduction of deformation induced by vibration movements in electronic devices such as Micro Inertial Measurement systems. The result is achieved by the use and particular arrangement of additional printed circuit boards.

## Description

### FIELD OF THE DISCLOSURE

This disclosure relates to electronic devices and more particularly to Micro Inertial Measurement Units. The present disclosure further concerns measurement units where chips are mounted on multiple surfaces which are perpendicular to each other.

### BACKGROUND OF THE DISCLOSURE

Electronic chips, which may also be called dies, are usually prepared by manufacturing various electronic structures on a substrate and cutting the substrate into small, chip-size pieces. Each chip can then be placed inside a protective package which forms an enclosure where the chip is protected from the surrounding environment. The chip can be mechanically attached to a support structure inside the enclosure, and electrically connected to contacts which extend outside of the enclosure. The packaged chip thereby forms an electronic component which can be mounted on a printed circuit board (PCB). Electronic components typically comprise at least one electronic chip and a package.

Microelectromechanical (MEMS) devices are electronic components which combine mechanical and electrical parts. They can have either simple or complex structures systems with various moving elements. MEMS devices include different type of sensors such as temperature sensors, pressure sensors and vibration sensors. Other examples of MEMS sensors are accelerometers, gyroscopes and magnetometers which are usually used in Micro Inertial Measurements Units (IMU).

A Micro Inertial Measurements Unit is an electronic device that measures the force, orientation, and/or angular velocity of an object to which it is attached. It usually comprises a combination of MEMS accelerometers, gyroscopes and sometimes magnetometers. The IMU measures linear acceleration using accelerometers and rotational rates using gyroscopes. When magnetometers are included in IMUs, they can alternatively measure the magnetic field. The accelerometers, gyroscopes and magnetometers are connected to PCBs which can be attached to each other according to various geometric arrangements. Figure 1 illustrates schematically a Micro Inertial Measurement system, disclosed in document US2013111993A1, where the sensing support is composed of three pieces of a gyro circuit board 100, 101 and 102, which are perpendicular to each other. The device comprises three one-axis gyroscopes 103 which are arranged on the circuit boards 100, 101 and 102. A problem with the use of such structures is that when the device undergoes vibrational movements due to applied accelerations, the PCBs experience mechanical deformation which directly impacts the MEMS components attached to them. Consequently, the components may be oriented in the wrong direction or may be damaged affecting thereby the measurement accuracy of the device.

### BRIEF DESCRIPTION OF THE DISCLOSURE

An object of the present disclosure is to provide a solution to the problem described above. The disclosed solution allows to reduce the deformation of the components induced by vibrational movements.

The object of the disclosure is achieved by an arrangement which is characterized by what is stated in the independent claims. The preferred embodiments of the disclosure are disclosed in the dependent claims.

The disclosure is based on the idea of reducing the amount of deformation by increasing the strength of the housing. This is achieved by arranging in perpendicular positions at least three vertical PCBs attached to a horizontal PCB. Multi-axis detection can be achieved by using multiple sensors, and reliability can be improved by using multiple sensors on the same axis. This provides new improvements in IMU device reliability.

### BRIEF DESCRIPTION OF THE DRAWINGS

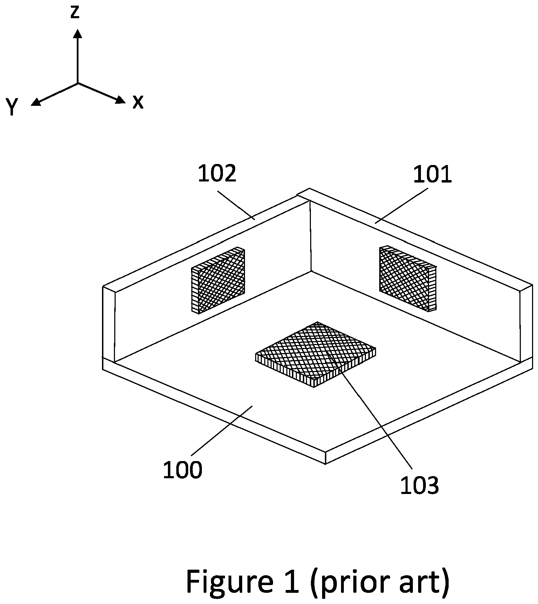

In the following, the disclosure will be described in greater detail by means of preferred embodiments with reference to the accompanying drawings, in which
Figures 1 illustrates a Micro Inertial Measurement System from the prior art comprising three circuit boards which are perpendicular to each other, and three gyroscopes which are attached to the circuit boards.
Figure 2a illustrates an arrangement comprising three vertical circuit boards which are attached to a horizontal printed circuit board. All the meeting circuit boards are perpendicular to each other. The vertical circuit boards form a U-shape.
Figure 2b illustrates an arrangement comprising four vertical circuit boards which are attached to a horizontal printed circuit board. All the meeting circuit boards are perpendicular to each other. The vertical circuit boards form a rectangle/square shape.
Figure 3 illustrates an electronic device comprising three vertical circuit boards which are attached to a horizontal printed circuit board, a first set of dies attached to the horizontal circuit board and a second set of dies attached to a vertical printed circuit board. The vertical circuit boards form a U-shape.
Figure 4a illustrates an electronic device comprising three vertical circuit boards which are attached to a horizontal printed circuit board, a first set of dies attached to the horizontal circuit board and two additional sets of dies attached to two vertical printed circuit boards. The vertical circuit boards form a U-shape.
Figure 4b illustrates an electronic device comprising three vertical circuit boards which are attached to a horizontal printed circuit board, a first set of dies attached to the horizontal circuit board and three additional sets of dies attached to the vertical printed circuit boards. The vertical circuit boards form a U-shape.
Figure 5 illustrates an electronic device comprising three vertical circuit boards which are attached to a horizontal printed circuit board and one die attached to each printed circuit board. The vertical circuit boards form a U-shape.
Figure 6 illustrates an electronic device comprising three vertical circuit boards which are attached to a horizontal printed circuit board, and four set of dies attached to the four circuit boards. Some dies are redundant dies. The vertical circuit boards form a U-shape.
Figure 7a illustrates a top view of the effects of vibrational movements on the shape of the circuit boards comprised in the electronic component. The vibrational movements occur in one direction, either along the x-axis, or along the y-axis.
Figure 7b illustrates a top view of the effects of vibrational movements on the shape of the circuit boards comprised in the electronic component. The vibrational movements occur along the x- and y- axes simultaneously.

### DETAILED DESCRIPTION OF THE DISCLOSURE

The disclosure describes an electronic device comprising a first circuit board where the first circuit board defines a horizontal xy-plane and a vertical z-direction which is perpendicular to the xy-plane. The first circuit board has an inside surface and an outside surface. The device also comprises a first set of dies which are connected to the first circuit board. The device further comprises a second circuit board which defines a xz-plane and a y-direction which is perpendicular to the xz-plane. The second circuit board also has an inside surface and an outside surface, and the device comprises a second set of dies which are connected to the second circuit board. The electronic device further comprises a third circuit board which defines a yz-plane and a x-direction which is perpendicular to the yz-plane. The third circuit board has an inside surface and an outside surface. The first, the second and the third circuit bords are attached to each other. The electronic device further comprises a fourth circuit board which is parallel to the third circuit board and attached to the first and the second circuit board

The device is intended to be mounted, for example onto an external object. Any side of the device could be attached to the surface of the external object. That external object could be oriented in any manner. Words such as "bottom" and "top", "above" and "below" do not refer to the orientation of the device with regard to the direction of earth's gravitational field either when the device is manufactured or when it is in use. The expressions "inside surface" and "outside surface" only refer to the two sides of a particular circuit board and their positions within the device. The inside surface of the circuit board is the side of the circuit board facing the center of the device, whereas the outside surface of the circuit board is the side which faces the surrounding of the device. The expression "horizontal" refers here to a position that is parallel to the xy-plane, whereas the expression "vertical" refers to a position that is perpendicular to the xy-plane.

The plane defined by the x- and y-axes is parallel to the plane of the first printed circuit board to which dies are attached. The direction defined by the z-axis is perpendicular to the same circuit board plane. The plane defined by the x- and z-axes is parallel to the second printed circuit board to which dies are attached. The direction defined by the y-axis is perpendicular to the same circuit board plane. The plane defined by the y- and z-axes is parallel to the planes of the third and fourth circuit boards to which dies are attached. The direction defined by the x-axis is perpendicular to the same circuit boards planes.

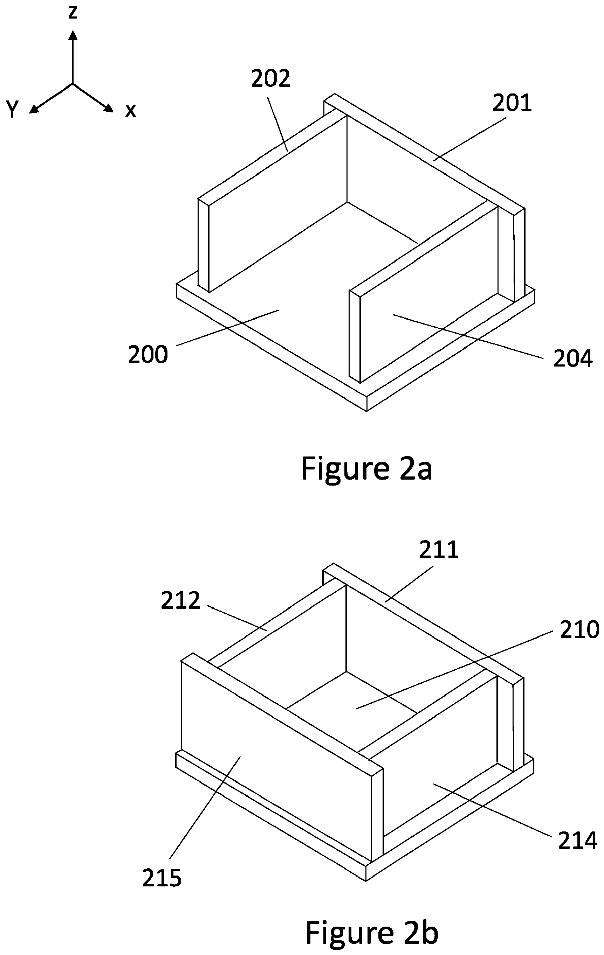

Figure 2a illustrates schematically an example of the geometry that may be formed by the printed circuit boards in such device. The device comprises a first horizontal circuit board 200 and additional three vertical circuit boards. The second circuit board 201, the third circuit board 202 and the fourth circuit board 204 are attached to the horizontal printed circuit board 200. The third circuit board 202 is parallel to the fourth circuit board 204. The second, the third, and fourth circuit boards may form a U-shape in the xy-plane and all the circuit boards that are attached to each other are perpendicular to each other. In other words, the circuit bords are arranged in a three-dimensional shape where every two meeting boards form a 90º angle on the device side which faces the center. One circuit board may also extend past an adjacent circuit board forming a 90º angle on the device side which faces the surrounding. Mounting at right angles may be performed by a variety of methods that include but are not limited to soldering, screwing, inserting, or gluing the circuit boards together. This mounting geometry provides structural rigidity which strengthens the housing.

Figure 2b illustrates schematically another example of the geometry that may be formed by the printed circuit boards in such device. The device comprises a horizontal first circuit board 210 and additional four vertical circuit boards. The second circuit board 211, the third circuit board 212 and the fourth circuit board 214 are attached to the first printed circuit board 210. The device may comprise a fifth circuit board 215 parallel to the second circuit board 211 and attached to the third 212 and the fourth circuit boards 214. The fifth circuit board has an inside surface and an outside surface. The second circuit board 211 is parallel to the fifth circuit board 215, whereas the third circuit board 212 is parallel to the fourth circuit board 214. All meeting circuit boards are perpendicular to each other. In other words, the circuit boards form a three-dimensional structure where the vertical boards are arranged in a rectangle/square-like shape. One circuit board may also extend past an adjacent circuit board forming a 90º angle on the device side which faces the surrounding. Reference numbers 210, 211, 212, and 214 in figure 2b correspond to reference numbers 200, 201, 202 and 204, respectively, in figure 2a.

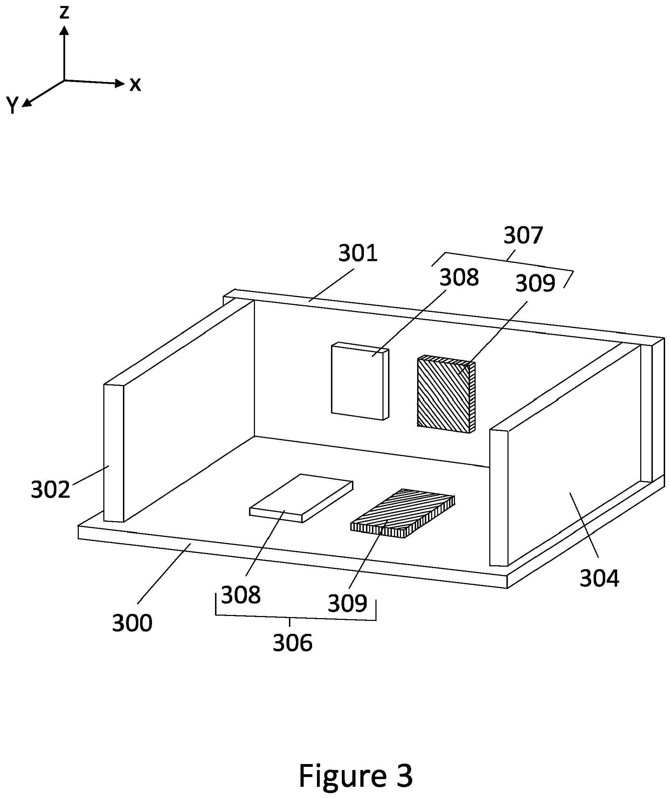

Figure 3 illustrates schematically an example of an electronic device comprising several printed circuit boards forming a U-shape in the xy-plane and dies connected to the printed circuit boards. The device may be a Micro Inertial Measurement Unit built using FP4, or FR4, or FR5, or CEM, or LTCC, or flexible PCB material, or any combination of these materials. These options apply to all embodiments in this disclosure. The device comprises a horizontal first circuit board 300 and three additional vertical circuit boards. The second circuit board 301, the third circuit board 302 and the fourth circuit board 304 are attached to the top side of the horizontal first printed circuit board 300, and the third circuit board 302 is parallel to the fourth circuit board 304. The device further comprises a first set of dies 306 which are connected to the first circuit board 300, and a second set of dies 307 which are connected to the second printed circuit board 301. The first set of dies 306 may comprise at least one gyroscope or at least one acceleration sensor. The second set of dies 307 may also comprise at least one gyroscope or at least one acceleration sensor. For example, the first set of dies 306 may comprise a gyroscope 308 and an acceleration sensor 309 and the second set of dies 307 may also comprise a gyroscope 308 and an acceleration sensor 309. Reference numbers 300, 301, 302, and 304 in figure 3 correspond to reference numbers 200, 201, 202 and 204, respectively, in figure 2a.

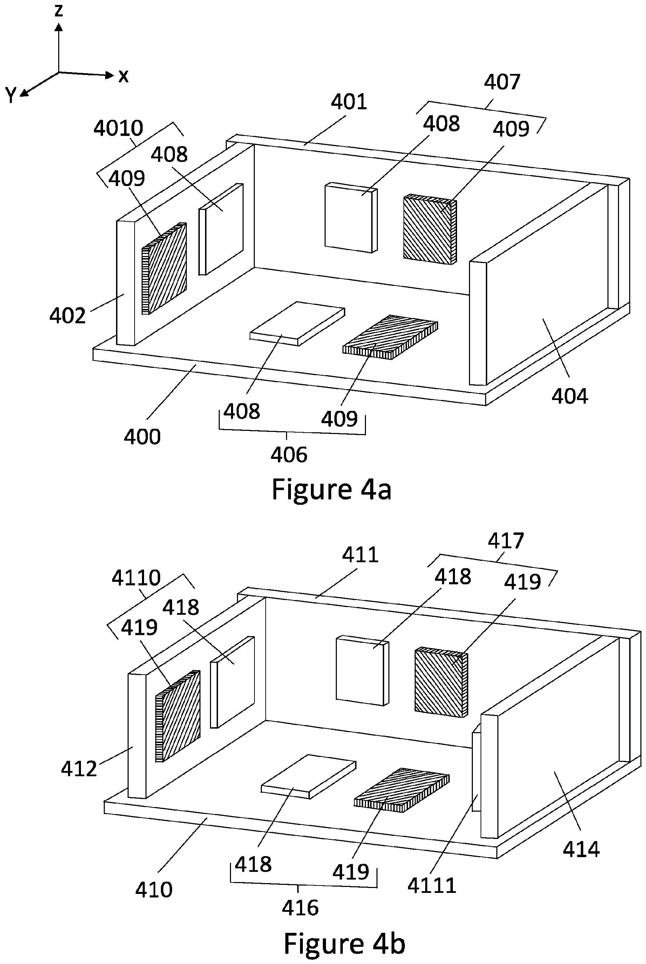

The device may further comprise a third set of dies and the third set of dies is connected to the third circuit board. Figure 4a illustrates schematically an example of an electronic device comprising several printed circuit boards forming a U-shape in the xy-plane and dies connected to the printed circuit boards. The device comprises a horizontal first circuit board 400 and three additional vertical circuit boards. The second circuit board 401, the third circuit board 402 and the fourth circuit board 404 are attached to the top side of the horizontal first printed circuit board 400, and the third circuit board 402 is parallel to the fourth circuit board 404. The device further comprises a first set of dies 406 which are connected to the first circuit board 400, a second set of dies 407 which are connected to the second printed circuit board 401, and a third set of dies 4010 which are connected to the third printed circuit board 402. For example, the first set of dies 406 may comprise a gyroscope 408 and an acceleration sensor 409. The second set of dies 407 may also comprise a gyroscope 408 and an acceleration sensor 409. The third set of dies 4010 may also comprise a gyroscope and an acceleration sensor 409. Reference numbers 400, 401, 402, 404, 406, 407, 408 and 409 in figure 4a correspond to reference numbers 300, 301, 302, 304, 306, 307, 308 and 309, respectively, in figure 3.

The device may further comprise a fourth set of dies and the fourth set of dies is connected to the fourth circuit board. Figure 4b illustrates schematically an example of an electronic device comprising several printed circuit boards forming a U-shape in the xy-plane and dies connected to the printed circuit boards. The device comprises a horizontal first circuit board 410 and three additional vertical circuit boards. The second circuit board 411, the third circuit board 412 and the fourth circuit board 414 are attached to the top side of the horizontal first printed circuit board 410, and the third circuit board 412 is parallel to the fourth circuit board 414. The device further comprises a first set of dies 416 which are connected to the first circuit board 410, a second set of dies 417 which are connected to the second printed circuit board 411, a third set of dies 4110 which are connected to the third printed circuit board 412, and a fourth set of dies 4111 which are connected to the fourth printed circuit board 414. The dies may for example be gyroscopes 418 and acceleration sensors 419. Reference numbers 410, 411, 412, 414, 416, 417, 418, 419 and 4110 in figure 4b correspond to reference numbers 400, 401, 402, 404, 406, 407, 408, 409 and 4010, respectively, in figure 4a.

The first set of dies may be connected to the inside surface of the first circuit board, the second set of dies may be connected to the inside surface of the second circuit board, the third set of dies may be connected to the inside surface of the third circuit board and the fourth set of dies may be connected to the inside surface of the fourth circuit board. Alternatively, one or more sets of dies could be placed on the outside surface of a circuit board.

Each of the first, second, third and fourth sets of dies may comprise one or more MEMS dies. For example, in one possible embodiment, when used in IMUs, the first set of dies may comprise a gyroscope and/or an acceleration sensor and the second set of dies may also comprise a gyroscope and/or an acceleration sensor. As a first additional option, the third set of dies may also comprise a gyroscope and/or an acceleration sensor. As a second additional option, the fourth set of dies may also comprise a gyroscope and/or an acceleration sensor.

Any gyroscope presented in this disclosure may be a single-axis or, 2-axis or 3-axis gyroscope and any acceleration sensor may be a single-axis or, 2-axis or 3-axis acceleration sensor. Any gyroscope may measure rotation rates about at least one axis. Correspondingly, any acceleration sensor may measure acceleration along at least one axis. This applies to all embodiments in this disclosure.

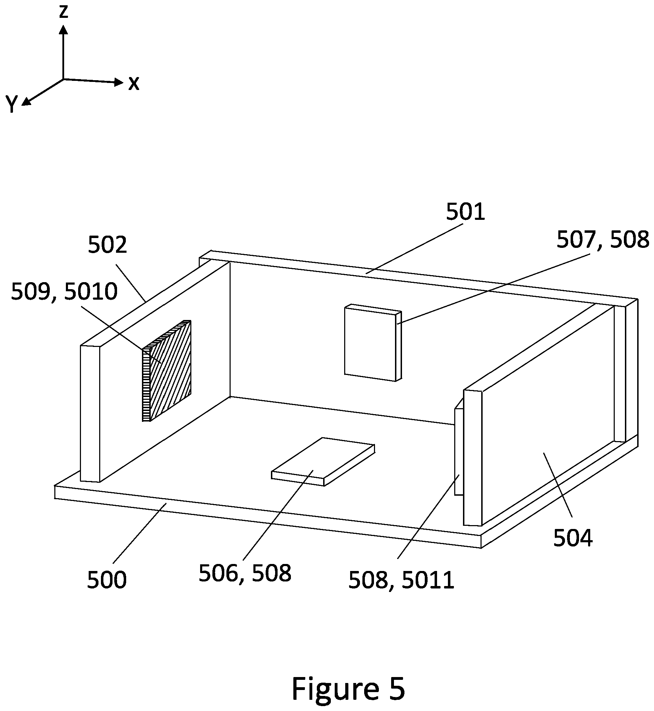

Figure 5 illustrates schematically an example of an electronic device comprising several printed circuit boards forming a U-shape in the xy-plane and dies connected to the printed circuit boards. The device comprises a horizontal first circuit board 500 and three additional vertical circuit boards. The second circuit board 501, the third circuit board 502 and the fourth circuit board 504 are attached to the top side of the horizontal first printed circuit board 500, and the third circuit board 502 is parallel to the fourth circuit board 504. The device further comprises a first set of dies 506 which are connected to the first circuit board 500, a second set of dies 507 which are connected to the second printed circuit board 501, a third set of dies 5010 which are connected to the third printed circuit board 502, and a fourth set of dies 5011 which are connected to the fourth printed circuit board 504. For example, in this embodiment the first set of dies 506 may be a gyroscope 508, the second set of dies 507 may also be a gyroscope 508, the third set of dies 5010 may be an acceleration sensor 509, and the fourth set of dies 5011 may also be a gyroscope 508. In this embodiment, the gyroscopes may be single-axis gyroscopes and the acceleration sensor may be a 3-axis acceleration sensor. Reference numbers 500, 501, 502, 504, 506, 507, 508, 509, 5010 and 5011 in figure 5 correspond to reference numbers 410, 411, 412, 414, 416, 417, 418, 419, 4110 and 4111, respectively, in figure 4b.

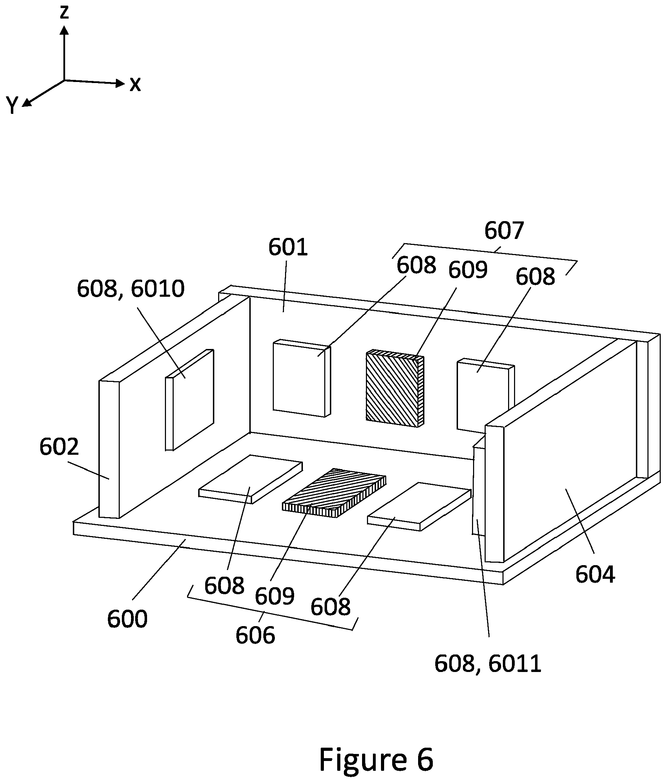

In another possible embodiment, the first set of dies may be a gyroscope and a 3-axis acceleration sensor, the second set of dies may be only a gyroscope, and the third set of dies may be only a gyroscope. To ensure measurement accuracy, redundant dies may as well be used. For example, the first set of dies may comprise at least two gyroscopes and one acceleration sensor, the second set of dies may comprise at least two gyroscopes and one acceleration sensor, the third set of dies may comprise at least one gyroscope, and the fourth set of dies may comprise at least one gyroscope. Figure 6 illustrates schematically an example of such electronic device. The device may be a Micro Inertial Measurement Unit which comprises a horizontal first circuit board 600, three additional vertical circuit boards forming a U-shape in the xy-plane and eight dies connected to the printed circuit boards. The second circuit board 601, the third circuit board 602 and the fourth circuit board 604 are attached to the top side of the horizontal first printed circuit board 600, and the third circuit board 602 is parallel to the fourth circuit board 604.The device comprises a first set of dies 606 which are connected to the first circuit board 600, a second set of dies 607 which are connected to the second printed circuit board 601, a third set of dies 6010 which are connected to the third printed circuit board 602 and a fourth set of dies 6011 which are connected to the fourth printed circuit board 604. In this embodiment, the first set of dies 606 may for example be a first gyroscope 608, a second gyroscope 608 and a first acceleration sensor 609. The first and second gyroscopes 608 may be single-axis gyroscopes whereas the acceleration sensor 609 may be a 3-axis acceleration sensor. The second gyroscope may be used to redundantly backup the first gyroscope. The second set of dies 607 may be a third gyroscope 608, a fourth gyroscope 608 and a second acceleration sensor 609. The third and fourth gyroscopes 608 may be single-axis gyroscopes, and the second acceleration sensor 609 may be a 3-axis acceleration sensor. The fourth gyroscope may be used to redundantly backup the third gyroscope. The third set of dies 6010 may be a fifth single-axis gyroscope 608, and the fourth set of dies 6011 may be a sixth single-axis gyroscope 608. The sixth gyroscope may be used to redundantly backup the fifth gyroscope. The second acceleration sensor may be used to redundantly backup the first acceleration sensor. Reference numbers 600, 601, 602, 604, 606, 607, 608, 609, 6010 and 6011 in figure 6 correspond to reference numbers 500, 501, 502, 504, 506, 507, 508, 509, 5010 and 5011, respectively, in figure 5.

The device may comprise a fifth printed circuit board parallel to the second circuit board and attached to the third and fourth circuit boards, where all meeting circuit boards are perpendicular to each other. The device may also comprise a fifth set of dies and the fifth set of dies are connected to the fifth circuit board. The fifth set of dies may be connected to the inside surface of the fifth circuit board. Alternatively, the fifth set of dies could be placed on the outside surface of the fifth circuit board.

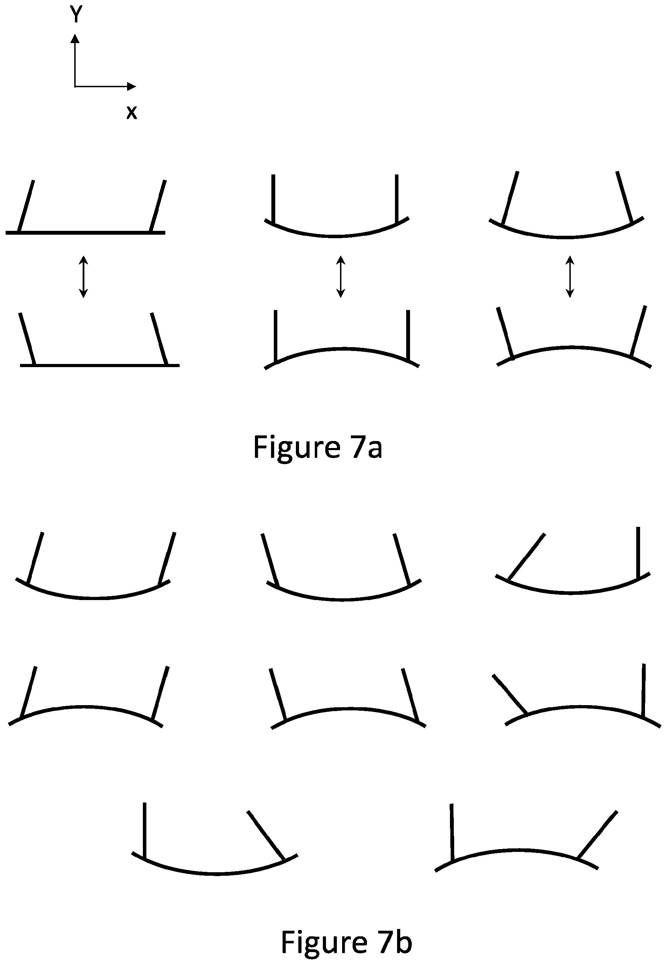

Figure 7a illustrates a top view of a device comprising three vertical circuit boards attached to a horizontal printed circuit board under the effects of vibrational movements which occur in one direction. When the device is not subject to any vibrational forces, the vertical circuit boards form a U shape in the xy-plane. The drawings on the left show the shape that vertical printed circuit boards may take when the device undergoes vibrations along the x-axis. Vibration movements may induce deformations which may lead to the shift of the parallel vertical third and fourth printed circuit boards from their initial positions towards the left and the right. In other words, a change in angle between the second and third printed circuit board as well as between the second and fourth circuit boards may take place in a repetitive manner. The initial right angle of 90º may change back and forth between values below 90º and above 90º. The drawings in the center show the shape that the vertical printed circuit boards may take when the device undergoes vibrations along the y-axis. Such movements may induce a deformation of the second printed circuit board along the y-axis which may lead to its bending towards the center of the device and away from the center of the device in a cyclic way. The deformation of the second printed circuit board may resemble then an alternation of a "smile" and a "sad" like shapes. The drawings on the right show the other shape that the vertical printed circuit boards may also take when the device undergoes stronger vibrations along the y-axis. Such vibration movements may induce deformations which may lead to the simultaneous shift of the parallel vertical third and fourth printed circuit boards from their initial positions towards the left and the right and to the bending of the second printed circuit board along the y-axis towards the center of the device and away from the center of the device.

Figure 7b illustrates a top view of a device comprising three vertical circuit boards attached to a horizontal printed circuit board under the effects of vibrational movements which occur in two directions. When the device is not subject to any vibrational forces, the vertical circuit boards form a U shape in the xy-plane. However, when the device undergoes vibrational movements that occur along the x- axis and the y- axis at the same time, deformation of the U shape may take place. This deformation may involve the simultaneous bending of the second circuit board towards or away from the center of the device and a shift of either the third circuit board, or the fourth circuit board, or the third and the fourth circuit board together from their initial position, depending on the strength of the vibrations.

## Claims

1. An electronic device comprising:
- A first circuit board, wherein the first circuit board defines a horizontal xy-plane and a vertical z-direction which is perpendicular to the xy-plane, and the first circuit board has an inside surface and an outside surface,
- a first set of dies connected to the first circuit board,
- a second circuit board which defines a xz-plane and a y-direction which is perpendicular to the xz-plane, and the second circuit board has an inside surface and an outside surface,
- a second set of dies connected to the second circuit board,
- a third circuit board which defines a yz-plane and a x-direction which is perpendicular to the yz-plane, and the third circuit board has an inside surface and an outside surface,
wherein the first, the second and the third circuit boards are attached to each other
**characterized in that**
the electronic device further comprises a fourth circuit board which is parallel to the third circuit board and attached to the first and the second circuit boards,

2. An electronic device according to claim 1, wherein the device further comprises a third set of dies and the third set of dies is connected to third circuit board,

3. An electronic device according to claims 1 and 2, wherein the device further comprises a fourth set of dies and the fourth set of dies is connected to the fourth circuit board.

4. An electronic device according to any of the previous claims, wherein each of the first, second, third and fourth sets of dies comprises one or more MEMS dies.

5. An electronic device according to any of the previous claims, wherein the first set of dies comprises at least one gyroscope or at least one acceleration sensor, and wherein the second set of dies comprises at least one gyroscope or at least one acceleration sensor.

6. An electronic device according to any of the previous claims, wherein the first set of dies comprises at least one gyroscope and one acceleration sensor, and wherein the second set of dies comprises at least one gyroscope and one acceleration sensor.

7. An electronic device according to any of the previous claims, wherein the first set of dies comprises at least two gyroscopes and one acceleration sensor, and wherein the second set of dies comprises at least two gyroscopes and one acceleration sensor, and wherein the third set of dies comprises at least one gyroscope, and wherein the fourth set of dies comprises at least one gyroscope.

8. An electronic device according to any of the previous claims, wherein the first set of dies is connected to the inside surface of the first circuit board, the second set of dies is connected to the inside surface of the second circuit board, the third set of dies is connected to the inside surface of the third circuit board and the fourth set of dies is connected to the inside surface of the fourth circuit board.

9. An electronic device according to any of the previous claims, where the second, the third and fourth circuit boards form a U-shape in the xy-plane.

10. An electronic device according to any of the previous claims, where there is a fifth circuit board parallel to the second circuit board and attached to the third and the fourth circuit boards and the fifth circuit board has an inside surface and an outside surface.

11. An electronic device according to claim 10, wherein the device has a fifth set of dies and wherein the fifth set of dies is connected to the fifth circuit board.
